# EUROPEAN PATENT APPLICATION

(11) **EP 4 646 089 A1**
(43) Date of publication of application: **05.11.2025**
(21) Application number: 25168140.9
(22) Date of filing: 02.04.2025
(51) Int. Cl.: H10N 70/00, B82Y 30/00, H01R 13/03, H05K 1/09

(54) **A COMMUNICATIONS LINK AND METHOD OF ACTIVATING A COMMUNICATIONS LINK**

(30) Priority: 26.04.2024 CA 3236581
(71) Applicant: Four's Company Investments Inc., St. Albert, AB T8N 6V4 (CA)
(72) Inventor: WHYTE, Douglas, Edmonton, T6R 3L4 (CA); WANG, Enmin, Irvine, 92612 (US)
(74) Representative: Appleyard Lees IP LLP

(57) **Abstract**

A communications link is provided that has a first linkage and a second linkage. The first linkage has a first electrical contact surface and a second electrical contact surface that are spaced from each other with a first nanoconductive polymer liquid or gel filling the space between them. The second linkage has a third electrical contact surface and a fourth electrical contact surface that are spaced from each other with a second nanoconductive polymer liquid or gel filling the space between them. The second linkage communicates with the first linkage through a Unified Field such that the first electrical contact surface is in contact with the fourth electrical contact surface.

## Description

### FIELD OF THE DISCLOSURE

The present application relates generally to a communications link that utilizes a Unified Field current flow path.

### BACKGROUND

This section provides background information to facilitate a better understanding of the various aspects of the invention. It should be understood that the statements in this section of this document are to be read in this light, and not as admissions of prior art.

At the inception and discovery of the field of quantum physics in the late 1800's and early 1900's, as was brought forth by advanced thinkers of the time including Albert Einstein, Max Planck, Sir Arthur Eddington, Sir James Jeans and others, it was proposed that beneath the physical structure of matter a level must exist that is non-matter, nonphysical, structured primarily of wave functions, probabilities, fundamental principles and laws of nature, and ultimately comprised, at the very deepest level, of the infinite, timeless, universal, unbounded "Unified Field", first expounded by Einstein. However, the group's concepts, proposals and perspectives were so foreign to the thinking of the classic matter-based physicist of the era as to be essentially incomprehensible.

Due to the apparent incomprehensibility for the matter-based thinker, the original thinking of Einstein and his contemporaries was abandoned in favor of a plethora of matter-based proposals and explanations that have propagated since then. To this day, these proposals are fraught with inexplicable conundrums and incongruities. Though still only having reached and explored the wave level, the study of quantum physics today is filled with the unexpected and the inexplicable, precisely because these original concepts and understandings have been abandoned. Even though incomplete or otherwise flawed, the varied models that replaced the original perspective have proven to be spectacularly useful for many discoveries including quantum electrodynamics. Quantum electrodynamics is often considered to be the most precisely understood and successful field in physics and is the basis of electronic equipment and products worldwide. Having a variety of different types of electronic equipment that operates in a different manner may be beneficial.

### BRIEF SUMMARY

There is provided a communications link that has a first linkage and a second linkage. The first linkage has a first electrical contact surface and a second electrical contact surface positioned such that a first space is created. A first bonded nanoconductive polymer layer is provided on the first electrical contact surface and a second bonded nanoconductive polymer layer is provided on the second electrical contact surface. The first bonded nanoconductive polymer layer and the second bonded nanoconductive polymer layer face into the first space such that the distance between the first bonded nanoconductive polymer layer and the second bonded nanoconductive polymer layer is between 1 nm and 100 nm wide. A first nanoconductive polymer liquid or gel fills the space between the first bonded nanoconductive polymer layer and the second bonded nanoconductive polymer layer.

The second linkage has a third electrical contact surface and a fourth electrical contact surface positioned such that a second space is created. A third bonded nanoconductive polymer layer is provided on the third electrical contact surface and a fourth bonded nanoconductive polymer layer is provided on the fourth electrical contact surface. The third bonded nanoconductive polymer layer and the fourth bonded nanoconductive polymer layer face into the second space such that the distance between the third bonded nanoconductive polymer layer and the fourth bonded nanoconductive polymer layer is between 1 nm and 100 nm wide. A second nanoconductive polymer liquid or gel fills the second space between the third bonded nanoconductive polymer layer and the fourth bonded nanoconductive polymer layer. The second electrical contact surface is in communication with the third electrical contact surface.

In one embodiment, the first electrical contact surface and the second electrical contact surface are parallel-plane plates of metal.

In one embodiment, the first electrical contact surface and the second electrical contact surface have no contact points extending greater than 20% of the first space.

In one embodiment, the third electrical contact surface and the fourth electrical contact surface are parallel-plane plates of metal.

In one embodiment, the third electrical contact surface and the fourth electrical contact surface have no contact points extending greater than 20% of the second space.

In one embodiment, the first linkage is connected to a first circuit and the second linkage is connected to a second circuit such that signals from the first circuit are sendable to the second circuit through the first link and the second link.

In one embodiment, signals from the second circuit are sendable to the first circuit through the second linkage and the first linkage.

There is also provided a method of activating a communications link that includes the steps of providing a local electronic device that has a first linkage and a remote electronic device that has a second linkage. The first linkage has a first electrical contact surface and a second electrical contact surface positioned such that a first space is created. A first bonded nanoconductive polymer layer is provided on the first electrical contact surface and a second bonded nanoconductive polymer layer is provided on the second electrical contact surface. The first bonded nanoconductive polymer layer and the second bonded nanoconductive polymer layer face into the first space such that the distance between the first bonded nanoconductive polymer layer and the second bonded nanoconductive polymer layer is between 1 nm and 100 nm wide. A first nanoconductive polymer liquid or gel fills the space between the first bonded nanoconductive polymer layer and the second bonded nanoconductive polymer layer. The second linkage has a third electrical contact surface and a fourth electrical contact surface positioned such that a second space is created. A third bonded nanoconductive polymer layer is provided on the third electrical contact surface and a fourth bonded nanoconductive polymer layer is provided on the fourth electrical contact surface. The third bonded nanoconductive polymer layer and the fourth bonded nanoconductive polymer layer face into the second space such that the distance between the third bonded nanoconductive polymer layer and the fourth bonded nanoconductive polymer layer is between 1 nm and 100 nm wide. A second nanoconductive polymer liquid or gel fills the second space between the third bonded nanoconductive polymer layer and the fourth bonded nanoconductive polymer layer. An electric current flow is established between the first linkage and the second linkage utilizing an activator assembly. The activator assembly physically and electrically connects the first linkage to the second linkage such that the electric current flows between the first linkage and the second linkage via the activator assembly through two simultaneous paths within the activator assembly. The first path is an electrical connection utilizing an electrical conductor between the first linkage and the second linkage. The second path is an electrical connection via an 'in situ' Unified Field current flow path between the first linkage and the second linkage such that the electric current flows between the first linkage, the activator assembly, and the second linkage. The activator assembly is disconnected from the first linkage and the second linkage while electric current flow continues such that the Unified Field current flow path remains intact between the first linkage and the second linkage and the second electrical contact surface is in remote communication with the third electrical contact surface.

In one embodiment, the first electrical contact surface and the second electrical contact surface are parallel-plane plates of metal.

In one embodiment, the first electrical contact surface and the second electrical contact surface have no contact points extending greater than 20% of the first space.

In one embodiment, the third electrical contact surface and the fourth electrical contact surface are parallel-plane plates of metal.

In one embodiment, the third electrical contact surface and the fourth electrical contact surface have no contact points extending greater than 20% of the second space.

In one embodiment, the first linkage is connected to a first circuit and the second linkage is connected to a second circuit such that signals from the first circuit are sendable to the second circuit through the first link and the second link.

In one embodiment, signals from the second circuit are sendable to the first circuit through the second linkage and the first linkage.

In one embodiment, the activator assembly is reintroduced to the first linkage and the second linkage to reestablish communication between the first linkage and the second linkage if communication is lost.

In one embodiment, the activator assembly is one of a mechanical switch, a digital switch, an electrically separable connector, a socket and a plug, and an electrical wire.

In one embodiment, the activator assembly is an integrated circuit having an electrical pin that provides physical contact between the first linkage and the second linkage.

In one embodiment, a point-to-point circuit is connected to the first linkage and the second linkage to re-establish communication between the first linkage and the second linkage if communication is lost.

In one embodiment, the point-to-point circuit is a fiber optic or conductive metal physical connect. A common conductive metal that is used is copper.

In another embodiment, the point-to-point circuit is a wireless internet link, radio link, or satellite link.

### BRIEF DESCRIPTION OF THE DRAWINGS

These and other features will become more apparent from the following description in which references are made to the following drawings, in which numerical references denote like parts. The drawings are for the purpose of illustration only and are not intended to in any way limit the scope of the invention to the particular embodiments shown.
FIG. 1 is a schematic view of the first linkage.
FIG. 2 is a representation of the resistive unified field transition regions in the first linkage.
FIG. 3 is a schematic view of the first linkage and the second linkage in series.
FIG. 4 is a schematic view of the first linkage and second linkage in series and attached to circuits, the first linkage and the second linkage attached by a conductor.
FIG. 5 is a schematic view of the first linkage and second linkage in series and attached to circuits with active current flow in a conductor and Unified Field current path.
FIG. 6 is a schematic view of the first linkage and second linkage in series and attached to circuits with active current flow in the Unified Field current path.
FIG. 7 is a schematic view of the local electronic device, remote electronic device, and activator assembly.
FIG. 8 is a schematic view of the first linkage and second linkage in series attached to circuits and having a point-to-point circuit.

### DETAILED DESCRIPTION OF THE PREFERRED EMBODIMENTS

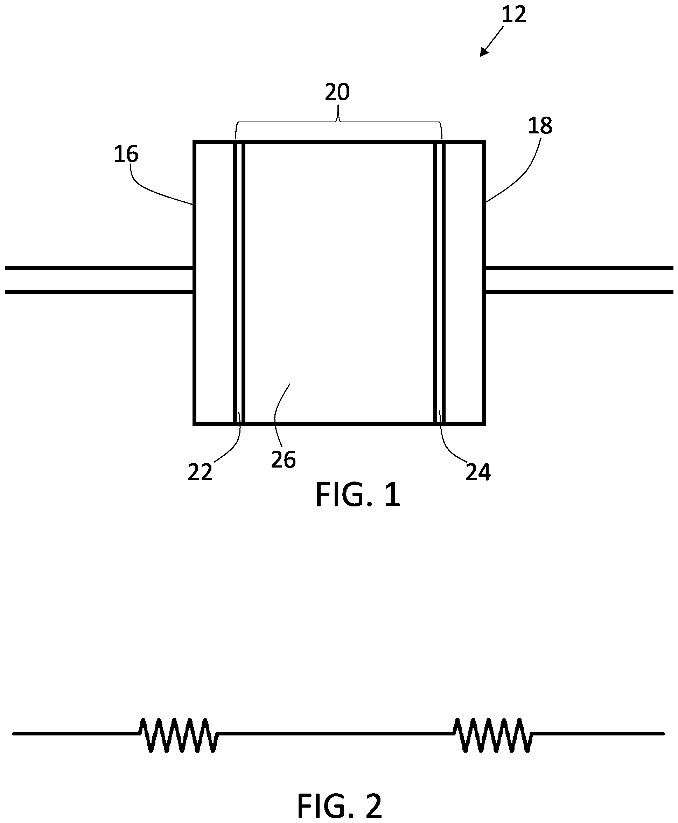

A communications link, generally identified by reference numeral 10, will now be described with reference to FIG. 1 through FIG. 8.

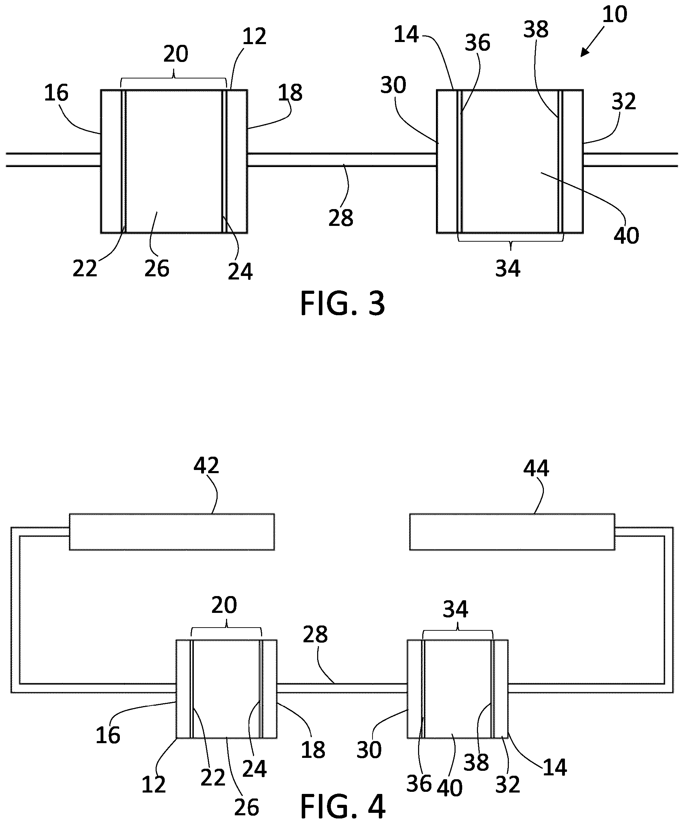

Referring to **FIG. 3****,** a communications link 10 has a first linkage 12 and a second linkage 14. Referring to **FIG. 1****,** first linkage 12 has a first electrical contact surface 16 and a second electrical contact surface 18 positioned such that a first space 20 is created. A first bonded nanoconductive polymer layer 22 is bonded to first electrical contact surface 16 and a second bonded nanoconductive polymer layer 24 is bonded to second electrical contact surface 18. First bonded nanoconductive polymer layer 22 and second bonded nanoconductive polymer layer 24 face into first space 20 such that the distance between first bonded nanoconductive polymer layer 22 and second bonded nanoconductive polymer layer 24 is between 1 nm and 100 nm wide. A first nanoconductive polymer liquid or gel 26 fills first space 20 between first bonded nanoconductive polymer layer 22 and second bonded nanoconductive polymer layer 24.

It is recommended that first electrical contact surface 16 and second electrical contact surface 18 be parallel-plane plates of metal. Parallel-plane plates are typically used in electronic devices and their shape may be flat, curved, square, circular, or any other suitable shape that is required to best support electron flow. Metals including, but not limited to, gold, silver, copper, tin, nickel, iron, lithium, aluminum, palladium, platinum, beryllium, and other rare earth metals are commonly used for these purposes. To prevent inadvertent contact between first electrical contact surface 16 and second electrical contact surface 18, irregularities in smoothness are preferably limited to extend no greater than 20% of first space 20. As an example, if first space 20 is 100 nm wide, 80 nm of the space should be free of the metal of first electrical contact surface 16 and second electrical contact surface 18. First electrical contact surface 16 may have an irregularity that extends 12 nm into first space 20 and second electrical contact surface 18 may have a corresponding irregularity that extends 8 nm into first space 20.

Referring to FIG. 3, second linkage 14 has a third electrical contact surface 30 and a fourth electrical contact surface 32 positioned such that a second space 34 is created. A third bonded nanoconductive polymer layer 36 is bonded on third electrical contact surface 30 and a fourth bonded nanoconductive polymer layer 38 is bonded to fourth electrical contact surface 32. Third bonded nanoconductive polymer layer 36 and fourth bonded nanoconductive polymer layer 38 face into second space 34 such that the distance between third bonded nanoconductive polymer layer 36 and fourth bonded nanoconductive polymer layer 38 is between 1 nm and 100 nm wide. A second nanoconductive polymer liquid or gel 40 fills second space 34 between third bonded nanoconductive polymer layer 36 and fourth bonded nanoconductive polymer layer 38.

It is recommended that third electrical contact surface 30 and fourth electrical contact surface 32 be parallel-plane plates of metal. Parallel-plane plates are typically used in electronic devices and their shape may be flat, curved, square, circular, or any other suitable shape that is required to best support electron flow. Conductive capacity of communications link 10 is dependent upon plate size, plate shape, and other properties known to a person skilled in the art. Metals including, but not limited to, gold, silver, copper, tin, nickel, iron, lithium, aluminum, palladium, platinum, beryllium, and other rare earth metals are commonly used for these purposes. To prevent inadvertent contact between third electrical contact surface 30 and fourth electrical contact surface 32, irregularities in smoothness are preferably limited to extend no greater than 20% of second space 34. As an example, if second space 34 is 1 nm wide, 0.8 nm of the space should be free of the metal of third electrical contact surface 30 and fourth electrical contact surface 32. Third electrical contact surface 30 may have an irregularity that extends 0.07 nm into second space 34 and fourth electrical contact surface 32 may have a corresponding irregularity that extends 0.05 nm into second space 20.

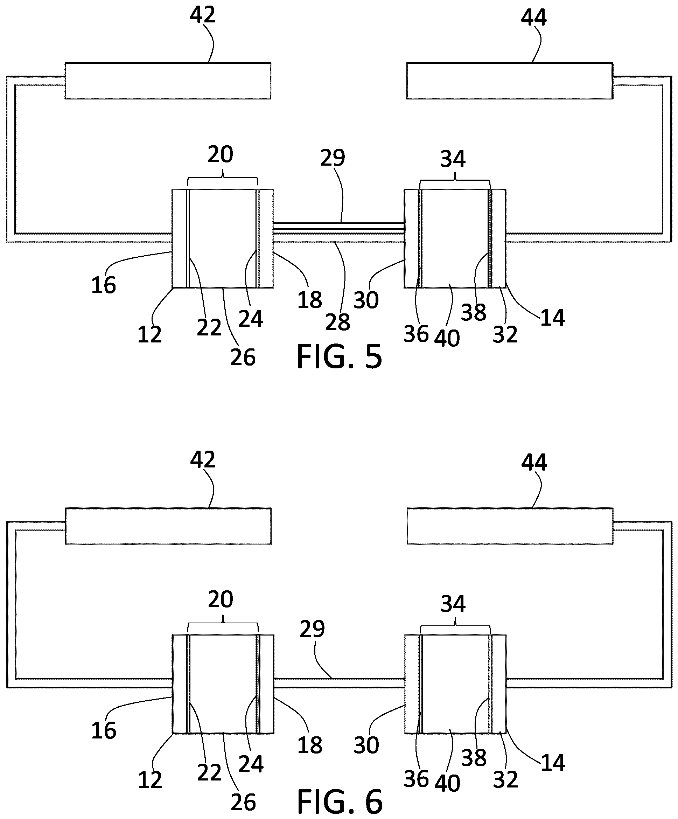

Referring to **FIG. 3 and Fig. 4****,** third electrical contact surface 30 of second linkage 14 is provided in communication with second electrical contact surface 18 of first linkage 12 through an electrical conductor 28. In the embodiment shown in **FIG. 5****,** second linkage 14 is provided in communication with first linkage 12 through an electrical conductor 28 and a Unified Field current flow path 29. In the embodiment shown in **FIG. 6****,** second linkage 14 is provided in communication with first linkage 12 through a Unified Field current flow path 29.

Referring to **FIG. 4****,** first linkage 12 may be connected to a first circuit 42 and second linkage 14 may be connected to a second circuit 44 such that signals from first circuit 42 are sendable to second circuit 44 through first linkage 12 and second linkage 14. Signals may be transmitted bidirectionally such that signals from second circuit 44 are sendable to first circuit 42 through second linkage 14 and first linkage 12. Multiple communications links 10 connected to circuits may be integrated into electronic equipment such that communication between linked circuits can occur over long distances utilizing communications links 10. An example would be the use of multiple communication links 10 connected to each of data, power, ground, control, or other electrical-function lines (digital or analog) such that communication between circuits can occur over long distances utilizing multiple communications links 10.

Applying first bonded nanoconductive polymer layer 22, second bonded nanoconductive polymer layer 24, third bonded nanoconductive polymer layer 36 and fourth bonded nanoconductive polymer layer 38 to the applicable electrical contact surface and incorporating first nanoconductive polymer liquid or gel 26 and second nanoconductive polymer liquid or gel 40 may be completed in any manner known to a person skilled in the art. An example of an application process includes the following steps:
1. Applying a chosen nanoconductive polymer to the applicable electrical contact surface by manual coating, machine-applied method, or by vacuum vapor deposition.
2. Bake the polymer on each surface at a temperature range of 125°C to 190°C for a time range of 5 seconds to 1000 hours. The polymer should be baked on each surface until electrical measurements indicate that for the temperature being used, further baking will produce only an arbitrarily small improvement in conductivity. For example, no further baking would be required where a 50% increase in baking time would achieve less than 10% improvement in conductivity. A person of skill can determine, based upon the use of the circuit, whether additional improvement to conductivity is worth the increased baking time. The temperature and time is adjusted to produce an optimally coated metal surface and may change depending upon the specific metal and polymer chosen.
3. After cooling to room temperature, the now nanoconductive polymer coated electrical contact surfaces are coated with a thin liquid or gel film of unbaked polymer.
4. First electrical contact surface 16 and second electrical contact surface 18 are moved into close proximity to create first space 20. Third electrical contact surface 30 and fourth electrical contact surface 32 are moved into close proximity to create second space 34. Excess polymer liquid or gel 26 and 40 is removed.
5. First linkage 12 may be encapsulated with a standard impervious coating such as plastic or ceramic as is known to a person skilled in the art and completed for other two-lead electronic devices. Second linkage 14 may be encapsulated with a standard impervious coating such as plastic or ceramic as is known to a person skilled in the art and completed for other two-lead electronic devices.

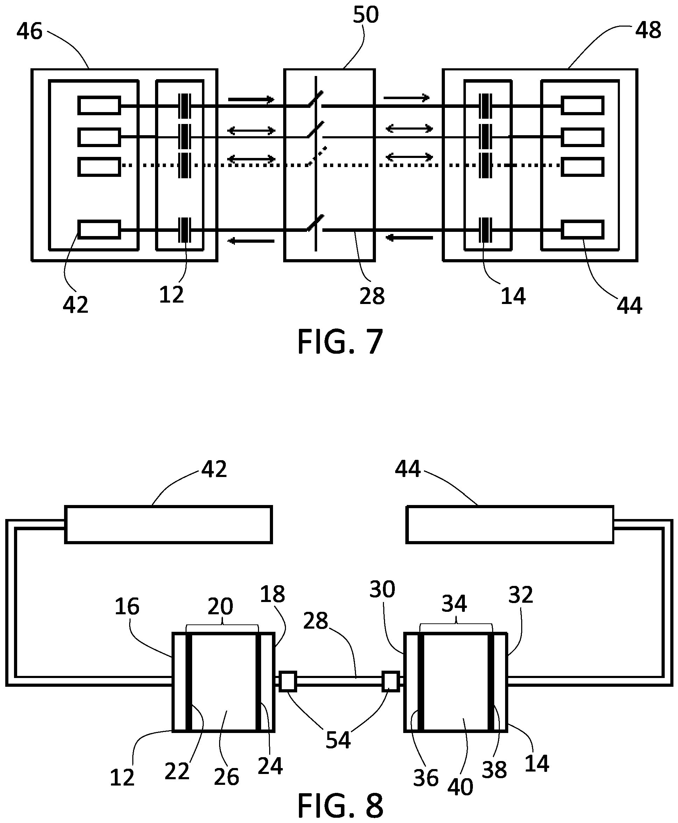

Referring to **FIG. 7****,** communications link 10 allows for remote communication between first circuit 42 and second circuit 44. In the embodiment shown, first circuit 42 and first linkage 12 are found in a local electronic device 46 and second circuit 44 and second linkage 14 are found in a remote electronic device 48. In the embodiment shown, four pairs of first linkage 12 and second linkage 14 are shown and create four subcircuits between local electronic device 46 and remote electronic device 48. It will be understood by a person skilled in the art that any number of pairs of first linkage 12 and second linkage 14 may be present in local electronic device 46 and remote electronic device 48 to accommodate multiple current flow paths. In order to operate remotely, each communication link 10 requires proper activation to allow first linkage 12 and second linkage 14 to connect and communicate with each other.

Multiple communication links 10 may be set up within a single pair of local electronic device 46 and remote electronic device 48 to accommodate multiple paths including the common collector voltage (Vcc), ground planes, and information circuits and each of these communication links 10 requires activation.

An activator assembly 50 is used to establish an isolated electric current flow between each first linkage 12 and corresponding second linkage 14 by creating a physical and electrical connection between each first linkage 12, activator assembly 50, and corresponding second linkage 14. Activator assembly 50 may consist of electrical conductor 28(s), a mechanical switch, digital switch, electrically separable connector, socket and plug, electric wire, integrated circuit with electrical pins, or any other suitable device known to a person skilled in the art.

Referring to **FIG. 4****,** electric current flow is established through the use of electrical conductor 28. Referring to **FIG. 5****,** once electrical current flow has been established, a Unified Field current flow path 29 is created. Referring to **FIG. 6****,** electrical conductor 28 is removed and only Unified Field current flow path 29 remains.

Referring to **FIG. 7****,** once electric current flow is established and while it is still flowing, activator assembly 50 disconnects electrical conductors 28 from first linkages 12 and second linkages 14. Referring to **FIG. 6****,** this leaves behind individual Unified Field current flow paths 29 that remain intact between first linkages 12 and second linkages 14 and allows for remote communication between second electrical contact surface 18 and third electrical contact surface 30. Unified Field current flow paths 29 allow first linkages 12 and second linkages 14 to remain in communication and locate each other while operational and without a physical connection. Once Unified Field current flow paths 29 have been established, remote electronic device 48 can be moved to any location with all communications between first linkage 12 and second linkage 14 remaining active. Referring to Fig .5, there is a brief passage of time as the current travels through second electrical contact surface 18, electrical conductor path 28, and third electrical contact surface 30, while in the simultaneously connected Unified Field Conductor 29, communication from first electrical contact surface 18 to third electrical contact surface 30 occurs virtually instantaneously via the Unified Field. This creates a temporary loss of bandwidth or echo in the circuit until the initialization step has completed, as has been detected in studies showing the presence of a comb filter effect occurring between first linkage 12 and second linkage 14. This effect suggests the presence of Unified Field communications.

In the event of a loss of communication between first linkage 12 and second linkage 14, activator assembly 50 may be reintroduced to any first linkage 12 and second linkage 14 that have lost communication to reestablish that communication. Referring to **FIG. 8****,** in situations where it is not practical to utilize activator assembly 50 or it is inconvenient to physically reestablish communication, a point-to-point circuit 54 may be provided that can be used to reestablish communication between individual first linkage 12 and second linkage 14 in the event that communication is lost. Point-to-point circuit 54 may be a physically connected fiber optic cable, copper wire, or any other suitable wired connection known to a person skilled in the art. Where physical connection is not practical, point-to-point circuit 54 may include wireless internet links, radio links, or satellite links. Point-to-point circuit 54 is generally in a disconnected and/or off state and is connected and/or turned on when needed to reestablish a connection between first linkage 12 and second linkage 14. Once the connection between first linkage 12 and second linkage 14 is reestablished, point-to-point circuit 54 is disconnected to reestablish Unified Field current flow path 29.

Referring to **FIG. 7****,** local electronic device 46 and remote electronic device 48 may be any suitable analog or digital device requiring wireless remote connections. Some examples include: a local and remote computer in communication with each other, electronic device subassemblies such as an audio preamplifier stage and a remote amplifier stage, a wireless video camera and base station, a cellular phone and remote power supply that provides power to the cellular phone without the need for a battery, a field-based sensor array and a fixed base station taking readings from the sensor, or a remote autonomous vehicle and base control station that includes power, data and control, and high power links for remote drive motors. It will be understood by a person skilled in the art that other types of local electronic device 46 and remote electronic device 48 may be used.

Referring to **FIG. 6****,** there are a number of potential benefits to utilizing communications link 10. Through Unified Field current flow path 29, electron flow may be bidirectionally instantaneous between local electronic device 46, shown in **FIG. 7****,** and remote electronic device 48, shown in **FIG. 7****.** Referring to **FIG. 7****,** combined circuits allow for current flow back to a source which helps to avoid any potential imbalances of electron fields. Data bandwidth is essentially infinite, limited only by the bandwidth of first circuit 42 and second circuit 44. No antennas are required for communication between first linkage 12 and second linkage 14. Local electronic device 46 and remote electronic device 48 can have any number of additional electrical connections including data lines, address lines, control lines, and analog signal lines. Data lines should be forward biased to ensure continuous connection between first linkage 12 and second linkage 14. Forward bias in this context indicates that the operational voltage is not allowed to pass through zero volts. The connections display zero to low time of travel, no signal loss, and no noise. Power transfer utilizing communications link 10 is possible, with current levels linearly dependent upon the physical surface area of the internal surfaces of first linkage 12 and second linkage 14. Unified Field current flow path 29 communications provide secure data transmission capabilities as there are no outward-directed or outer-level connections that occur. Communications link 10 displays a single point source and single point destination with no outer means of breaking into Unified Field current flow path 29.

Communications link 10 must remain active to maintain a connection between first linkage 12 and second linkage 14. Referring to **FIG. 7****,** communications link 10 may be inactivated by turning off either local electronic device 46 or remote electronic device 48 as this will break Unified Field current flow path 29 as this ends current flow between first linkage 12 and second linkage 14. As a result, it is preferable that neither local electronic device 46 nor remote electronic device 48 have an on-off switch to help prevent such an occurrence. Local electronic device 46 and remote electronic device 48 may enter an idle state as long as a minimal current flow continues to flow between first linkage 12 and second linkage 14. If current flow stops, reestablishment of Unified Field current flow path 29 using activator assembly 50 or point-to-point circuit 54, shown in **FIG. 8****,** may occur. For bi-directional connections such as data lines, current flow should be biased from first linkage 12 to second linkage 14 to help ensure that a minimal current flow is maintained.

When used for mission-critical applications, it is recommended that a second communications link 10 be provided for redundancy purposes. For power redundancy, an internal battery can provide back up. An internal battery may be charged through a separate communications link 10 or locally at a remote site, such as through utilizing a wall outlet or generator.

Referring to **FIG. 3****,** in lab studies an increase of electron flow across the circuit (in this case from first electrical contact surface 16 to fourth electrical contact surface 32) is detected by the measuring ohmmeter as an apparent reduced resistivity. In lab studies, a change from an average of 4.3 Ω to 2.94 Ω is seen. We propose that this is the result of a virtual Unified Field current flow path in parallel with the normal resistance of the metals of the dry circuit. Considering the electronic interaction from a mathematical point of view:
1. The complete "dry" series circuit (i.e., no baked polymer applied first electrical contact surface 16, second electrical contact surface 18, third electrical contact surface 30, and fourth electrical contact surface 32, and no liquid or gel polymer) measures 4.3 Ω, consisting of
   i. First electrical contact surface 16 and second electrical contact surface 18, in direct physical contact such that there is no first space 20, contributing 0.1Ω,
   ii. Third electrical contact surface 30 and fourth electrical contact surface 32, in direct physical contact such that there is no second space 34, contributing 0.1Ω,
   iii. electrical conductor 28, contributing 4.1 Ω.
2. With first bonded nanoconductive polymer layer 22, second bonded nanoconductive polymer layer 24, and first nanoconductive polymer liquid or gel 26 applied (the "wet" condition), first linkage 12 resistance drops by 5%, from 0.1 Ω to 0.095 Ω. With third bonded nanoconductive polymer layer 36, fourth bonded nanoconductive polymer layer 38, and second nanoconductive polymer liquid or gel 40 applied, second linkage 14 resistance drops by a similar amount. First linkage 12 and second linkage 14 together should therefore measure 0.095 Ω + 0.095 Ω = 0.19Ω.
3. However, the circuit's overall "wet" resistance drops to 2.94 Ω. Of this, electrical conductor 28 is therefore contributing 2.94-0.19=2.75 Ω.
4. This is an electrical conductor 28 resistance decrease of 4.1 - 2.75 = 1.35 Ω, a percentage drop of 32.9%.
5. Assuming that electrical conductor 28 conducts the same regardless of whether first linkage 12 and second linkage 14 are in the "wet" condition or the "dry" condition, we are therefore seeing an effective parallel circuit consisting of a 4.1Ω metal electrical conductor 28 together with the introduction of a Unified Field current flow path 29 of resistance N in parallel with electrical conductor 28. To determine N, the formula for resistances in parallel is Rₚ=R₁*R₂/(R₁+R₂).
6. Solving:
   4.1*N / (4.1+N) =2.75,
   4.1N=11.275+2.75N,
   1.35N=11.275,
   N=8.35Ω.
7. The Unified Field current flow path 29 thus measures 8.35 Ω.
8. 2.75/8.35=32.9%. About 1/3 of the current flow is Unified Field conduction.
9. Even though the Unified Field current flow path 29 appears to be nonexistent from the relative point of view - that is, the time of transfer is zero, i.e., the flow is essentially instantaneous - it is still displaying a small resistance. This is a reasonable effect. The connection exists in the material world and thus must display a resistance. Flow is not unlimited, but that limit is of no consequence in the operation of the circuit.

Referring to **FIG. 6****,** in a completed, active communications link 10, free electron flow is caused to travel through Unified Field current flow path 29 between first electrical contact surface 16 to fourth electrical contact surface 32. It may also be assumed, with no effective change to outcomes, that free electron flow is caused to travel through Unified Field current flow path 29 between first electrical contact surface 16 via first bonded nanoconductive polymer layer 22 and/or liquid or gel nanoconductive polymer layer 26 and/or second bonded nanoconductive polymer layer 24, in remote telecommunications with third bonded nanoconductive polymer layer 36 and/or second liquid or gel nanoconductive polymer layer 40 and/or fourth bonded nanoconductive polymer layer 38 to be reestablished in standard atom-to-atom free electron flow in fourth electrical contact surface 32.

Communications link 10 utilizes the scientific principles of Unified Field theory to operate. The operational principles proposed herein may be superseded or updated by other plausible principles without negating the functionality of communications link 10. Operation of communications link 10 operates based on the following principles:
1. First bonded nanoconductive polymer layer 22, first nanoconductive polymer liquid or gel 26, and second bonded nanoconductive polymer layer 24 in first linkage 12 act as both quantum electron tunnelling conductors and given the conditions described herein, become electron Unified Field conduction initiators. That is, in the distances encountered between first electrical contact surface 16 and second electrical contact surface 18 (100 nm or less) first linkage 12 acts as a quantum tunneling conductor. The same is seen in second linkage 14 with third bonded nanoconductive polymer layer 36, second nanoconductive polymer liquid or gel 40, and fourth bonded nanoconductive polymer layer 38, in the distances of third electrical contact surface 30 and fourth electrical contact surface 32 (100 nm or less). Secondly, under the conditions of communications link 10 they become a distance-independent Unified Field conduction initiators.
2. Communications link 10 connects first linkage 12 and second linkage 14 in series.
3. Referring to **FIG. 3****,** macro scale electron tunnelling is occurring at the subatomic scale between the metal and the nanoconductive polymer in the plate interface at two locations: between first electrical contact surface 16 and second electrical contact surface 18 with macro-scale tunneling electron flow between first bonded nanoconductive polymer layer 22, first nanoconductive polymer liquid or gel 26, and second bonded nanoconductive polymer layer 24, and again between third electrical contact surface 30 and fourth electrical contact surface 32, with macro-scale tunneling electron flow between locations third bonded nanoconductive polymer layer 36, second nanoconductive polymer liquid or gel 40, and fourth bonded nanoconductive polymer layer 38.
4. To summarize, first electrical contact surface 16 and fourth electrical contact surface 32 are initially connected by bonded polymer layers 22, 24, 36, 38, first nanoconductive polymer liquid or gel 26, second nanoconductive polymer liquid or gel 40, second electrical contact surface 18, third electrical contact surface 30, and electrical conductor 28 via either standard atom-to-atom free electron flow or by electron tunneling.
5. As described herein, initiation or completion of Unified Field current flow is thought to occur at the subatomic level within the nanoconductive polymer/metal interface at first bonded nanoconductive polymer layer 22 & fourth bonded nanoconductive polymer layer 38. Thus, Unified Field conduction occurs between first electrical contact surface 16 and fourth electrical contact surface 32, directly bypassing all elements in between. Notably, Unified Field current flow path 29 bypasses electrical conductor 28 between them once current begins to flow.
6. To initiate Unified Field electron flow, a common voltage is initially applied across the entire circuit resulting in simultaneous, identical electron flow in first linkage 12 and second linkage 14.
7. An initial condition has thus been set up, i.e., a voltage is applied across the nanoconductive polymer-coated metal plates. This initiates uniform free electron flow along all available paths.
8. Referring to **FIG. 4****,** if free electrons are flowing left to right, initial flow is:
   a. Entering from a connected circuit 42 via standard atom-to-atom free electron flow to first electrical contact surface 16;
   b. Changing to electron tunneling at first bonded nanoconductive polymer layer 22, to first nanoconductive polymer liquid or gel 26, to second bonded nanoconductive polymer layer 24;
   c. Changing to standard atom-to-atom free electron flow in second electrical contact surface 18, electrical conductor 28, and third electrical contact surface 30;
   d. Changing again to electron tunneling at third bonded nanoconductive polymer layer 36, to second nanoconductive polymer liquid or gel 40, to fourth bonded nanoconductive polymer layer 38;
   e. Changing to standard atom-to-atom free electron flow at fourth electrical contact surface 32 and exiting to a connected circuit 44.
9. Referring to **FIG. 5****,** simultaneous free electron flow also occurs through the Unified Field current flow path 29, through first bonded nanoconductive polymer layer 22 to fourth bonded nanoconductive polymer layer 38, adding to standard atom-to-atom free electron flow.
10. Current flow will occur where any path is available, with the lower resistance path resulting in higher current flow in that path.
11. By the well-known formula I=E/R, Current (I) flows in a conductor of resistance R based on the "pressure" applied by a voltage E. This voltage is applied across the full circuit.
12. Referring to **FIG. 3****,** if electrons are flowing from left to right, voltage-driven electron tunneling commences in first linkage 12 within the nanoconductive polymer-metal interface between first electrical contact surface 16 and first bonded nanoconductive polymer layer 22, first nanoconductive polymer liquid or gel 26, second bonded nanoconductive polymer layer 24, and second electrical contact surface 18. Owing to the series configuration of the circuit, simultaneous identical voltage-driven electron tunneling also occurs in second linkage 14.
13. This identical dual-position electron tunneling under common voltage creates the condition for Unified field conduction utilizing the superposition capability of the electron. Unified Field conduction begins as the electron "settles" towards the Unified Field level. In the process, electrons settle to first become their operating principles, during which time normal resistance to flow is encountered, and then the Unified Field level of pure Existence is reached.
14. With the settling phase now completed, resistance to electron flow drops to zero. Space, i.e., distance, does not exist at this level. Under the unique conditions of the circuit, an opportunity for Unified Field electron flow is created between first linkage 12 and second linkage 14 at first bonded nanoconductive polymer layer 22 and fourth bonded nanoconductive polymer layer 38. Source and destination electron are one at this level; resistivity between them is obviously zero.
15. In communications link 10, with the nanoconductive polymer acting as a Unified Field initiator, the Unified Field current flow path requires jumping across the infinite "gap" from inward settling layers of relative structure to absolute pure existence of the Unified Field. To do so, all structure must be transcended into a state consisting of one property that permeates and overarches everything - pure Existence.
16. The entire electron jump across the gap of the Unified Field occurs instantaneously and effortlessly (that is, without energy loss) outside of the time/space continuum.
17. The full Unified Field current flow path is the path of transcendence from electron wave into and out of the Unified Field, through two multiple-stage steps, an inward step and an outward step, the second the reverse of the first.
18. To clarify, the electron as a wave and the matter-like level above it exist as one. In the process of Unified Field electron conduction, the electron settles through distinct steps to become the Unified Field, ultimately ceasing to exist at the initial location in first bonded nanoconductive polymer layer 22.
19. From the moment the annihilation operator takes effect, all subsequent settling steps must, by definition, transcend the electron structure described by mathematics to become pure principles of intelligence.
20. Commencing with the electron as wave:
   a. The Inward Step
      i. Initial conditions: The electron as wave consists of all principles, laws of structure, etc. of the electron, in balance and effect. The principles do not simply describe the electron wave; they are the electron wave.
      ii. Additionally, the initial quantum conditions in our device and circuit include (but are not necessarily limited to) the existence of:
         1. innate knowledge of the structure of the circuit,
         2. presence of the intimately bonded nanoconductive polymer,
         3. ability of the polymer to support electron tunneling,
         4. tunneling capability of the electron,
         5. the principle of all electrons existing as a single electron,
         6. superposition capability of the electron,
         7. preference of the path of shortest distance, in this case through the Unified Field,
         8. preference of the path of least resistance, in this case through the Unified Field,
         9. a metal current path of a low, non-zero resistance,
         10. a common voltage placed electrically across the circuit,
         11. and an atom-to-atom flow of free electrons in the circuit.
      iii. Step One. The mathematical annihilation operator takes effect in the polymer, triggering electron tunneling.
      iv. Step Two. The wave settles to become the individual principles of the electron described by (but not limited to) the above.
      v. Step Three. The individual principles that are the electron simply settle to become their primary quality, that of pure Existence. The wave becomes the ocean, the Unified Field. At this point only the Unified Field exists, a singular condition of Pure Existence.
   b. The Outward Step
      i. The electron superposition at the destination location must simultaneously receive a new electron to fulfill the requirement in place prior to the collapse - that of free electron flow in the circuit, driven by the circuit-wide common voltage. To fulfill that requirement, the silence of the Unified Field is stirred into action as follows:
         1. Initial condition: The Unified Field has one property, Pure Existence. Existence is without boundary. It must exist everywhere and in all forms and cases.
         2. From the singular property of Pure Existence, the Unified Field must by definition express the quality of infinity and thus become greater.
         3. Everything in the cosmos displays three fundamental properties, it is either the knower, the known or the process of knowing.
         4. That is, the electron "knows" itself, i.e., it follows its operating design principles exactly.
         5. The Unified Field as Pure Existence automatically displays those three properties found everywhere, within itself.
         6. The Unified Field "splits into the three", yet still within itself. It becomes knower, known and the process of knowing, in a state of full self-referral.
         7. The Unified Field is a singularity, Pure Existence. And yet it is simultaneously the three. It is thus vibrating within itself at infinite frequency between one (the Self, pure existence) and three (knower, known and the process of knowing).
         8. The Unified Field has now begun the first level of vibration, that is, to express itself.
         9. The Unified Field current flow path and ultimate destination is already known, defined by the common voltage.
         10. Thus, at the next step the intent to express becomes the principles of structure of the electron. In conformance with the pre-existing condition of electron acting in superposition, all principles, laws of structure and properties of the electron and electron flow are expressed as the free electron at the new position, which then continues to travel through the remote circuit under the force of the voltage.
         11. This outward flow has occurred spontaneously based on layers of logically self-supportive interacting principles.
      ii. Expressed another way, because the applied voltage demands electron flow, from the silence of the absolute a tendency to create occurs. This wave rises up to become a vibration, oscillating between pure Existence and the existent at infinite frequency. Existence in this case becomes the principle of the electron with all its inherent properties, laws and structures in place under influence of the applied voltage, to then become an electron wave, to interact with a metal atom at the destination site, completing the chain to become a free electron and continue electron flow in the circuit.
      iii. The new electron wave is simultaneously and instantaneously formed out of the Unified Field, first becoming a principle of action, then becoming a wave, then reappearing in the destination metal as an electron. Thus, the process has occurred entirely within the quantum field with the electron wave disappearing from one point and simultaneously reappearing at the destination.
21. Viewed from perspective of superposition, there are not multiple electrons. The electron exists within the quantum field, and because within the quantum field dimensions of neither time nor space exist, there can be only one electron, with the property of native intelligence and operating principles of the electron, existing in a state of potential superposition with all other electrons in the universe. It simultaneously appears in potential in multiple places, all places at the same moment.
22. Guided by the applied voltage, the electron displays entanglement with the electron appearing in the destination metal. The two electrons do not even "exist" in two places at once in superposition; both are in fact one electron, one side of itself simultaneously "disappearing", collapsing into the Unified Field, and the other side of itself reappearing out of the Unified Field into the electron wave in the destination metal, where it then becomes a free electron of the destination copper atoms, induced to downstream electron flow in fourth electrical contact surface 32.
23. Thus, the principle that energy can neither be created nor destroyed is maintained. It simultaneously destroys itself and recreates itself in the same instant, at apparently infinite speed.
24. Further to this scenario, we have created a condition whereby two such quantum active connector interfaces are active and interconnected by an interconnecting metal electrical conductor 28. This means that the voltage which is inducing electron flow is now a common voltage influencing the entire structure, and thus a condition of series electron flow exists, that is, identical electron flow in all series sections of the circuit. Because of this common voltage and the direct physical connection via the interconnecting electrical conductor 28, the tunneling electrons in both connector regions are induced to superposition between the two well-defined tunneling environments. The principle of the electron existing in all places simultaneously, coupled with common-voltage-driven simultaneous electron tunneling in the two plate regions, induces electron flow through the Unified Field as the shortest path, i.e., no distance, by its superposition principle from first linkage 12 to second linkage 14. Entanglement, if necessary, may occur to maintain electron spin.
25. This is native-intelligence-mediated conformance to path-of-least-resistance electron flow, across the entire communications link 10, triggering electron wave collapse into the Unified Field and its reverse, facilitated by the intimate presence of quantum electron tunneling initiator media.
26. Further, as the electron collapses into the Unified Field in first linkage 12, at the same instant the electron flows outward in second linkage 14. Thus, electron balance is maintained in the metal. On the 'output' side, an electron is not arriving by atom-to-atom flow; rather a wholly new electron is being created out of the Unified Field, resulting in the metal at the site being maintained in effectively "brand new" condition, with the metal's property of free electron conductivity being continually and fully refreshed by the creation of a stream of wholly new electrons which then flow back to the source via the ground path, thus maintaining charge balance.

Any use herein of any terms describing an interaction between elements is not meant to limit the interaction to direct interaction between the subject elements, and may also include indirect interaction between the elements such as through secondary or intermediary structure unless specifically stated otherwise.

In this patent document, the word "comprising" is used in its non-limiting sense to mean that items following the word are included, but items not specifically mentioned are not excluded. A reference to an element by the indefinite article "a" does not exclude the possibility that more than one of the element is present, unless the context clearly requires that there be one and only one of the elements.

It will be apparent that changes may be made to the illustrative embodiments, while falling within the scope of the invention. As such, the scope of the following claims should not be limited by the preferred embodiments set forth in the examples and drawings described above, but should be given the broadest interpretation consistent with the description as a whole.

## Claims

1. A communications link comprising:
a first linkage, comprising:
a first electrical contact surface and a second electrical contact surface positioned such that a first space is created,
a first bonded nanoconductive polymer layer on the first electrical contact surface and a second bonded nanoconductive polymer layer on the second electrical contact surface, the first bonded nanoconductive polymer layer and the second bonded nanoconductive polymer layer facing into the first space, the distance between the first bonded nanoconductive polymer layer and the second bonded nanoconductive polymer layer being between 1 nm and 100 nm wide;
a first nanoconductive polymer liquid or gel filling the first space between the first bonded nanoconductive polymer layer and the second bonded nanoconductive polymer layer;
the first electrical contact surface being in electron tunneling communication with the second electrical contact surface;
a second linkage in communication with the first linkage through a Unified Field current flow path, comprising:
a third electrical contact surface and a fourth electrical contact surface positioned such that a second space is created,
a third bonded nanoconductive polymer layer on the third electrical contact surface and a fourth bonded nanoconductive polymer layer on the fourth electrical contact surface, the third bonded nanoconductive polymer layer and the fourth bonded nanoconductive polymer layer facing into the second space, the distance between the first bonded nanoconductive polymer layer and the second bonded nanoconductive polymer layer being between 1 nm and 100 nm wide;
a second nanoconductive polymer liquid or gel filling the second space between the third bonded nanoconductive polymer layer and the fourth bonded nanoconductive polymer layer;
the third electrical contact surface being in electron tunneling communication with the fourth electrical contact surface.

2. The communications link of claim 1 wherein the first electrical contact surface and the second electrical contact surface are parallel-plane plates of metal.

3. The communications link of claim 1 wherein the first electrical contact surface and the second electrical contact surface have no contact points extending greater than 20% of the first space.

4. The communications link of claim 1 wherein the third electrical contact surface and the fourth electrical contact surface are parallel-plane plates of metal.

5. The communications link of claim 1 wherein the third electrical contact surface and the fourth electrical contact surface have no contact points extending greater than 20% of the second space.

6. The communications link of claim 1 wherein the first linkage is connected to a first circuit and the second linkage is connected to a second circuit such that signals from the first circuit are sendable to the second circuit through the first linkage and the second linkage.

7. The communications link of claim 6 wherein the signals from the second circuit are sendable to the first circuit through the second linkage and the first linkage.

8. A method of activating a communications link, comprising the steps of:
providing a local electronic device have a first linkage, the first linkage comprising:
a first electrical contact surface and a second electrical contact surface positioned such that a first space is created,
a first bonded nanoconductive polymer layer on the first electrical contact surface and a second bonded nanoconductive polymer layer on the second electrical contact surface, the first bonded nanoconductive polymer layer and the second bonded nanoconductive polymer layer facing into the first space, the distance between the first bonded nanoconductive polymer layer and the second bonded nanoconductive polymer layer being between 1 nm and 100 nm wide;
a first nanoconductive polymer liquid or gel filling the first space between the first bonded nanoconductive polymer layer and the second bonded nanoconductive polymer layer;
providing a remote electronic device having a second linkage, the second linkage comprising:
a third electrical contact surface and a fourth electrical contact surface positioned such that a second space is created,
a third bonded nanoconductive polymer layer on the third electrical contact surface and a fourth bonded nanoconductive polymer layer on the fourth electrical contact surface, the third bonded nanoconductive polymer layer and the fourth bonded nanoconductive polymer layer facing into the second space, the distance between the first bonded nanoconductive polymer layer and the second bonded nanoconductive polymer layer being between 1 nm and 100 nm wide;
a second nanoconductive polymer liquid or gel filling the second space between the third bonded nanoconductive polymer layer and the fourth bonded nanoconductive polymer layer;
establishing an electric current flow between the first linkage and the second linkage utilizing an activator assembly, the activator assembly physically and electrically connecting the first linkage to the second linkage, the physical connection utilizing an electrical conductor removably attachable to the first linkage and the second linkage, the electrical connection being a Unified Field current flow path between the first linkage and the second linkage created after electric current flow is established, electric current flowing between the local electronic circuit, the first linkage, the activator assembly, the second linkage and the remote electronic circuit; and
disconnecting the activator assembly from the first linkage and the second linkage while electric current flow continues such that a Unified Field current flow path remains intact between the first linkage and the second linkage and the first electrical contact surface is in remote communication with the fourth electrical contact surface.

9. The method of claim 8 wherein the first electrical contact surface and the second electrical contact surface are parallel-plane plates of metal, and the third electrical contact surface and the fourth electrical contact surface are parallel-plane plates of metal.

10. The method of claim 8 wherein the first electrical contact surface and the second electrical contact surface have no contact points extending greater than 20% of the first space.

11. The method of claim 8 wherein the third electrical contact surface and the fourth electrical contact surface have no contact points extending greater than 20% of the second space.

12. The method of claim 8 wherein the first linkage is connected to a first circuit and the second linkage is connected to a second circuit such that signals from the first circuit are sendable to the second circuit through the first linkage and the second linkage.

13. The method of claim 8 wherein the activator assembly is reintroduced to the first linkage and the second linkage to reestablish communication between the first linkage and the second linkage if communication is lost.

14. The method of claim 8 wherein the activator assembly is one of a mechanical switch, a digital switch, an electrically separable connector, a socket and a plug, and an electrical wire.

15. The method of claim 8 wherein a point-to-point circuit is connected to the first linkage and the second linkage to re-establish communication between the first linkage and the second linkage if communication is lost.
